# EUROPEAN PATENT APPLICATION

(11) **EP 4 779 683 A1**
(43) Date of publication of application: **22.07.2026**
(21) Application number: 24881402.2
(22) Date of filing: 09.10.2024
(51) Int. Cl.: H01L 21/67, F23D 14/02

(54) **IGNITION CHAMBER OF SEMICONDUCTOR PROCESS DEVICE, SEMICONDUCTOR PROCESS DEVICE AND CONTROL METHOD**

(30) Priority: 24.10.2023 CN 202311385409
(71) Applicant: Beijing NAURA Microelectronics Equipment Co., Ltd., Beijing 100176 (CN)
(72) Inventor: FANG, Yang, Beijing 100176 (CN); KONG, Xiangtian, Beijing 100176 (CN)
(74) Representative: Cohausz & Florack
(86) International application number: PCT/CN2024/123579
(87) International publication number: WO 2025/087036

(57) **Abstract**

The present disclosure provides an ignition chamber of a semiconductor process equipment, a semiconductor process equipment, and a control method. In the ignition chamber of the semiconductor process equipment, one end of a communication pipeline and one end of a purge pipeline respectively communicate with a first end of a combustion chamber, and the other end of the purge pipeline is configured to communicate with a combustion-supporting gas source; and one end of an exhaust pipeline, one end of a first gas inlet pipeline, and one end of a second gas inlet pipeline respectively communicate with a second end of the combustion chamber opposite to the first end of the combustion chamber, the other end of one of the first gas inlet pipeline and the second gas inlet pipeline is configured to communicate with a combustible gas source, and the other end of the other of the first gas inlet pipeline and the second gas inlet pipeline is configured to communicate with the combustion-supporting gas source. The ignition chamber can solve the problem that when purging is performed on an existing ignition chamber before the existing ignition chamber is used for a wet oxidation process, part of oxygen flows into a process chamber and undergoes a dry oxidation process with a workpiece to be processed, which hinders the subsequent wet oxidation process.

## Description

### TECHNICAL FIELD

The present disclosure belongs to the field of semiconductor processing technology, and particularly relates to an ignition chamber of a semiconductor process equipment, a semiconductor process equipment, and a control method.

### BACKGROUND

In a semiconductor processing process, forming a silicon dioxide film on a silicon wafer is a relatively fundamental process. At present, process methods for forming the silicon dioxide film typically include a dry oxidation process, a steam oxidation process, and a wet oxidation process. Taking account of factors such as film formation speed and film formation quality, the wet oxidation process is a film formation process which is more widely applied.

In the wet oxidation process, in order to avoid introducing impurities, high-purity hydrogen and oxygen are typically directly used to burn in an ignition chamber to generate water vapor; and by introducing excessive oxygen into the ignition chamber, it is ensured that what is introduced into a process chamber is a mixture of the water vapor and oxygen, so that the wet oxidation process may be performed using the water vapor and oxygen.

However, when the wet oxidation process is performed with the existing ignition chamber, since the excessive oxygen needs to be delivered into the ignition chamber through an oxygen delivery pipeline before ignition, part of the excessive oxygen may flow into the process chamber and undergo a dry oxidation process with a workpiece to be processed to form a high-density film, which hinders the subsequent wet oxidation process.

### SUMMARY

Embodiments of the present disclosure aim to provide an ignition chamber of a semiconductor process equipment, a semiconductor process equipment, and a control method, so as to at least solve the problem that when purging is performed on an existing ignition chamber before the existing ignition chamber is used for a wet oxidation process, part of oxygen flows into a process chamber and undergoes a dry oxidation process with a workpiece to be processed, which hinders the subsequent wet oxidation process.

In a first aspect, an embodiment of the present disclosure provides an ignition chamber of a semiconductor process equipment, including a combustion chamber, a communication pipeline, a purge pipeline, an exhaust pipeline, a first gas inlet pipeline, and a second gas inlet pipeline, wherein
one end of the communication pipeline and one end of the purge pipeline respectively communicate with a first end of the combustion chamber, and the other end of the purge pipeline is configured to communicate with a combustion-supporting gas source; and
one end of the exhaust pipeline, one end of the first gas inlet pipeline, and one end of the second gas inlet pipeline respectively communicate with a second end of the combustion chamber opposite to the first end of the combustion chamber, the other end of one of the first gas inlet pipeline and the second gas inlet pipeline is configured to communicate with a combustible gas source, and the other end of the other of the first gas inlet pipeline and the second gas inlet pipeline is configured to communicate with the combustion-supporting gas source.

In a second aspect, an embodiment of the present disclosure provides a semiconductor process equipment, including a process chamber and the above ignition chamber of the semiconductor process equipment, and one end of the communication pipeline away from the combustion chamber communicates with the process chamber.

In a third aspect, an embodiment of the present disclosure provides a control method applied to the above semiconductor process equipment, including:
controlling both the first gas inlet pipeline and the second gas inlet pipeline to be closed, and controlling both the purge pipeline and the exhaust pipeline to be opened;
after a preset time period passes, controlling the purge pipeline and the exhaust pipeline to be closed; and
controlling both the first gas inlet pipeline and the second gas inlet pipeline to be opened.

In the ignition chamber of the semiconductor process equipment provided in the embodiment of the present disclosure, the first end of the combustion chamber is provided with the communication pipeline and the purge pipeline, the second end of the combustion chamber is provided with the exhaust pipeline, the first gas inlet pipeline, and the second gas inlet pipeline, one of the first gas inlet pipeline and the second gas inlet pipeline may communicate with the combustible gas source, and the other of the first gas inlet pipeline and the second gas inlet pipeline may communicate with the combustion-supporting gas source, so as to introduce a combustible gas and a combustion-supporting gas into the combustion chamber for a combustion reaction. Meanwhile, the purge pipeline may communicate with the combustion-supporting gas source, so that before the combustion reaction occurs in the ignition chamber, the combustion-supporting gas may be introduced into the combustion chamber in advance through the purge pipeline to replace an original gas in the combustion chamber, which can avoid pollution to a workpiece to be processed. Moreover, since the purge pipeline and the communication pipeline are located at the same end of the combustion chamber and the exhaust pipeline at the other end of the combustion chamber can also be opened while the purge pipeline is being opened, the original gas in the combustion chamber and the combustion-supporting gas introduced through the purge pipeline hardly flows into the process chamber through the communication pipeline, which can prevent the workpiece to be processed in the process chamber from being subjected to a dry oxidation process, and further improve processing efficiency and process effect of a wet oxidation process.

### BRIEF DESCRIPTION OF DRAWINGS

The drawings described here are intended to provide a further understanding of the present disclosure and constitutes a part of the present disclosure. The exemplary embodiments of the present disclosure and the description thereof are intended to explain the present disclosure, but do not constitute improper limitation to the present disclosure. In the drawings:
FIG. 1 is a schematic diagram illustrating an operation mode of an ignition chamber according to an embodiment of the present disclosure;
FIG. 2 is a schematic diagram illustrating another operation mode of an ignition chamber according to an embodiment of the present disclosure;
FIG. 3 is a schematic structural diagram of a semiconductor process equipment according to an embodiment of the present disclosure; and
FIG. 4 is a flowchart illustrating a control method according to an embodiment of the present disclosure.

### Reference numerals:

100-combustion chamber, 110-first cylinder, 120-second cylinder, 130-communicating section,
210-communication pipeline, 220-purge pipeline, 230-exhaust pipeline, 240-first gas inlet pipeline, 250-second gas inlet pipeline,
300-dispersion plate,
400-heating element,
500-process chamber.

### DETAIL DESCRIPTION OF EMBODIMENTS

The technical solutions provided in the embodiments of the present disclosure are clearly and thoroughly described below with reference to the drawings for the embodiments of the present disclosure. Apparently, the embodiments described herein are just some embodiments of the present disclosure, and do not cover all embodiments. All other embodiments derived by those of ordinary skill in the art from the embodiments described herein without inventive work fall within the scope of the present disclosure.

The terms "first", "second" and the like in the description and the claims of the present disclosure are used for distinguishing between similar objects, but not for describing a particular order or a chronological order. It should be understood that the data such used may be interchanged under appropriate circumstances, so as to allow the embodiments of the present disclosure to be implemented in an order other than those illustrated or described herein; and the objects distinguished by the terms "first", "second" and the like generally belong to one kind, and the number of the objects is not limited, for example, the number of a first object may be one or more. In addition, the term "and/or" in the description and the claims indicates at least one of the objects connected by the term "and/or", and the forward slash "/" generally indicates that the object before "/" and the object after "/" are in an "or" relationship.

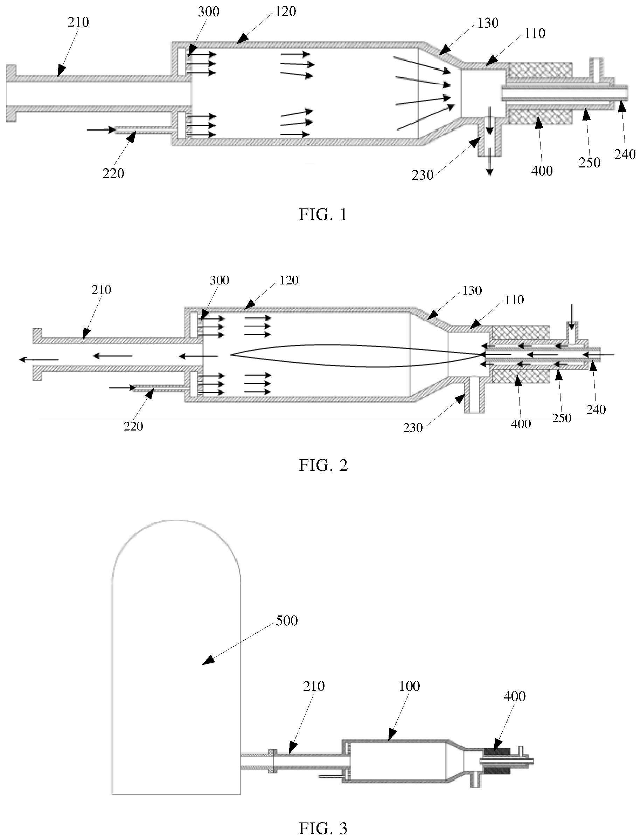

As shown in FIG. 1 to FIG. 3, an embodiment of the present disclosure provides an ignition chamber of a semiconductor process equipment (hereinafter referred to as the "ignition chamber"), and the ignition chamber serves as a container for a combustion reaction of a combustible gas, so that the combustible gas and a combustion-supporting gas can burn in the ignition chamber to generate a material required for semiconductor processing, such as water. That is, the ignition chamber can cooperate with a process chamber 500 of the semiconductor process equipment to perform a corresponding process on a semiconductor. As shown in FIG. 1 to FIG. 3, the ignition chamber includes a combustion chamber 100, a communication pipeline 210, a purge pipeline 220, an exhaust pipeline 230, a first gas inlet pipeline 240, and a second gas inlet pipeline 250.

The combustion chamber 100 provides a space for the combustion reaction between the combustible gas and the combustion-supporting gas, and may be made of quartz or other high-temperature-resistant materials, and all parameters such as a volume and a shape of the combustion chamber 100 may be determined based on actual situations. Certainly, in order to ensure that the combustible gas has good combustion effect and high combustion efficiency and a combustion product can be discharged out of the combustion chamber 100 easily and completely, the combustion chamber 100 typically has a straight structure, that is, two opposite ends of the combustion chamber 100 are distributed along a straight direction, which is an axial direction of the combustion chamber 100.

The communication pipeline 210, the purge pipeline 220, the exhaust pipeline 230, the first gas inlet pipeline 240, and the second gas inlet pipeline 250 are all configured to deliver gases, and the communication pipeline 210 may be further configured to deliver the combustion product. All parameters such as diameters of the communication pipeline 210, the purge pipeline 220, the exhaust pipeline 230, the first gas inlet pipeline 240, and the second gas inlet pipeline 250 may be determined flexibly based on actual situations, and are not limited herein. Since the communication pipeline 210 may be further configured to deliver the combustion product having a relatively high temperature, the communication pipeline 210 may be made of a high-temperature-resistant material such as quartz or metal.

In addition, in order to ensure that the gases delivered into the combustion chamber 100 through the first gas inlet pipeline 240 and the second gas inlet pipeline 250 can undergo the combustion reaction, the gas delivered through at least one of the first gas inlet pipeline 240 and the second gas inlet pipeline 250 needs to be heated. In an embodiment of the present disclosure, the combustible gas and the combustion-supporting gas which have temperatures exceeding an ignition point may be directly delivered into the combustion chamber 100 through the first gas inlet pipeline 240 and the second gas inlet pipeline 250, so that the combustible gas and the combustion-supporting gas may mix and then burn in the combustion chamber 100.

In order to reduce process difficulty and improve combustion reliability, in other embodiments of the present disclosure, the semiconductor process equipment further includes a heating element 400; and by sleeving the heating element 400 over the first gas inlet pipeline 240 and the second gas inlet pipeline 250, the gases in the first gas inlet pipeline 240 and the second gas inlet pipeline 250 can be heated, so that the temperatures of the gases delivered into the combustion chamber 100 through the first gas inlet pipeline 240 and the second gas inlet pipeline 250 can meet an ignition temperature. In an embodiment, the second gas inlet pipeline 250 may be sleeved over the first gas inlet pipeline 240, the combustible gas may be delivered into the combustion chamber 100 through the first gas inlet pipeline 240, and the combustion-supporting gas may be delivered into the combustion chamber 100 through an annular channel between an inner wall of the second gas inlet pipeline 250 and an outer wall of the first gas inlet pipeline 240, so that the degree of mixing of the combustion-supporting gas and the combustible gas is increased to improve combustion efficiency and combustion completeness of the combustible gas. For respective ports of the first gas inlet pipeline 240 and the second gas inlet pipeline 250 which communicate with gas sources, the port of the first gas inlet pipeline 240 may be located at an end, and the port of the second gas inlet pipeline 250 may be located on a sidewall of the second gas inlet pipeline 250.

In a process of assembling the ignition chamber, one end of the communication pipeline 210 and one end of the purge pipeline 220 respectively communicate with a first end of the combustion chamber 100, and the other end of the purge pipeline 220 communicates with a combustion-supporting gas source, so that the combustion-supporting gas can be delivered into the combustion chamber 100 through the purge pipeline 220. In an embodiment, the combustion-supporting gas may be oxygen. The other end of the communication pipeline 210 may communicate with the process chamber 500, so that the combustion products and the excessive oxygen in the combustion chamber 100 can be delivered into the process chamber 500 for a wet oxidation process.

Moreover, one end of the exhaust pipeline 230, one end of the first gas inlet pipeline 240, and one end of the second gas inlet pipeline 250 respectively communicate with a second end of the combustion chamber 100 opposite to the first end of the combustion chamber 100, the other end of one of the first gas inlet pipeline 240 and the second gas inlet pipeline 250 communicates with a combustible gas source, and the other end of the other of the first gas inlet pipeline 240 and the second gas inlet pipeline 250 communicates with the combustion-supporting gas source, so that the combustible gas and the combustion-supporting gas can be delivered into the combustion chamber 100, and the combustible gas can burn under the condition that the temperatures of the combustible gas and the combustion-supporting gas meets the ignition point and the combustible gas and the combustion-supporting gas mix in the combustion chamber 100. In an embodiment of the present disclosure, for performing the wet oxidation process, the combustible gas is hydrogen, and the combustion-supporting gas is oxygen, which ensures that the combustion product of the combustible gas and the combustion-supporting gas is just water. Moreover, the oxygen introduced into the combustion chamber 100 is in an excess state, that is, a volume ratio of hydrogen to oxygen is less than 2:1. In some examples, the volume ratio of hydrogen to oxygen introduced into the combustion chamber 100 may be 1:1, which ensures complete combustion of hydrogen. The exhaust pipeline 230 may be connected to a plant exhaust, so that a gas discharged from the combustion chamber 100 through the exhaust pipeline 230 can be delivered to the plant exhaust to be discharged and treated.

Based on the ignition chamber provided in the embodiments of the present disclosure, before the ignition chamber is used for the wet oxidation process, the combustion-supporting gas may be introduced into the combustion chamber 100 in advance through the purge pipeline 220, with the exhaust pipeline 230 opened. Thus, an original gas in the combustion chamber 100 and the introduced combustion-supporting gas can be discharged from the combustion chamber 100 through the exhaust pipeline 230, and the combustion chamber 100 only contains the combustion-supporting gas, which prevents other gases or impurities from causing pollution to a film forming process. Moreover, since the exhaust pipeline 230 is kept open while introducing the combustion-supporting gas into the combustion chamber 100 through the purge pipeline 220, the gas in the combustion chamber 100 can generally flow in a direction away from the communication pipeline 210, so that the flowing of the combustion-supporting gas into the process chamber 500 communicating with the communication pipeline 210 can be greatly reduced or even avoided, the original gas in the combustion chamber 100 can be basically prevented from flowing into the process chamber 500, and it is ensured that a dry oxidation process of a workpiece to be processed in the process chamber 500 hardly occurs.

In addition, when expelling the original gas and the impurities from the combustion chamber 100, in order to prevent gas impurities from reacting with oxygen to generate precipitates and other substances that cannot be discharged out of the combustion chamber 100, excessive nitrogen may be introduced before oxygen is introduced through the purge pipeline 220, so as to replace the original gas in the combustion chamber 100; then, oxygen is introduced into the combustion chamber 100 through the purge pipeline 220 to replace nitrogen. During the introduction of nitrogen, a type of the gas source connected to one of the first gas inlet pipeline 240 and the second gas inlet pipeline 250 may be changed for the introduction of nitrogen into the combustion chamber 100. In another embodiment of the present disclosure, nitrogen may be delivered into the combustion chamber 100 through the purge pipeline 220, so as to minimize or even prevent the flowing of nitrogen into the process chamber 500 through the communication pipeline 210; after the introduction of nitrogen lasts for a period of time, the gas source connected to the purge pipeline 220 may be changed, and oxygen may be further delivered into the combustion chamber 100 , so as to replace nitrogen in the combustion chamber 100.

In the ignition chamber of the semiconductor process equipment provided in the embodiments of the present disclosure, the first end of the combustion chamber 100 is provided with the communication pipeline 210 and the purge pipeline 220, the second end of the combustion chamber 100 is provided with the exhaust pipeline 230, the first gas inlet pipeline 240, and the second gas inlet pipeline 250; and one of the first gas inlet pipeline 240 and the second gas inlet pipeline 250 may communicate with the combustible gas source, and the other of the first gas inlet pipeline 240 and the second gas inlet pipeline 250 may communicate with the combustion-supporting gas source, so as to introduce the combustible gas and the combustion-supporting gas into the combustion chamber 100 for the combustion reaction. Meanwhile, the purge pipeline 220 may communicate with the combustion-supporting gas source, so that before the combustion reaction occurs in the ignition chamber, the combustion-supporting gas may be introduced into the combustion chamber 100 in advance through the purge pipeline 220 to replace the original gas in the combustion chamber 100, which can avoid pollution to the workpiece to be processed. Moreover, since the purge pipeline 220 and the communication pipeline 210 are located at the same end of the combustion chamber 100 and the exhaust pipeline 230 at the other end of the combustion chamber 100 can also be opened while the purge pipeline 220 is being opened, the original gas in the combustion chamber 100 and the combustion-supporting gas introduced through the purge pipeline 220 hardly flows into the process chamber 500 through the communication pipeline 210, which can prevent the workpiece to be processed in the process chamber 500 from being subjected to the dry oxidation process, and further improve processing efficiency and process effect of the wet oxidation process.

Based on the above embodiments, in the process of introducing hydrogen into the ignition chamber, if a relatively large amount of raw materials is needed for the wet oxidation process, an input flow rate of hydrogen needs to be relatively large within a same process time, resulting in a relatively high flow velocity of hydrogen. Due to the relatively high flow velocity of hydrogen, part of hydrogen may be directly delivered into the process chamber 500 before undergoing the combustion reaction in the ignition chamber, and may further react with oxygen in the process chamber 500 to generate a large amount of heat, which causes a significant adverse effect on temperature uniformity in the process chamber 500, and further leads to failure in the film formation process of the semiconductor.

In view of this, when the ignition chamber provided in the embodiments of the present disclosure is used for the combustion reaction, if the flow rate of hydrogen is relatively large, the combustion-supporting gas may also be introduced into the combustion chamber 100 through the purge pipeline 220 during the introduction of the combustion-supporting gas through one of the first gas inlet pipeline 240 and the second gas inlet pipeline 250. Since a flow direction of the combustion-supporting gas introduced into the combustion chamber 100 through the purge pipeline 220 is opposite to that of hydrogen, the combustion-supporting gas and hydrogen may mix to generate turbulence. Thus, on the one hand, the flow velocity of hydrogen can be reduced; on the other hand, the degree of mixing of hydrogen and oxygen can be improved to increase a combustion rate of hydrogen, combustion completeness of hydrogen can be improved, and the phenomenon that hydrogen directly flows into the process chamber 500 through the communication pipeline 210 without burning in the combustion chamber 100 can be greatly alleviated or even avoided.

In addition, in a case where the combustion-supporting gas is introduced into the combustion chamber 100 through the purge pipeline 220, the volume ratio of the combustible gas and the combustion-supporting gas which are delivered into the combustion chamber 100 through the first gas inlet pipeline 240 and the second gas inlet pipeline 250 may be kept unchanged; or a volume of the combustion-supporting gas delivered into the combustion chamber 100 through the first gas inlet pipeline 240 or the second gas inlet pipeline 250 may be properly reduced based on actual situations, so as to keep the volume ratio of the combustible gas and the combustion-supporting gas introduced into the combustion chamber 100 unchanged under the condition that the combustion-supporting gas is also introduced into the combustion chamber 100 through the purge pipeline 220. That is, the volume of the combustion-supporting gas delivered into the combustion chamber 100 needs to be always kept larger than a volume of the combustible gas. It should be noted that under the condition that a weight of the combustion product needed by the process is kept unchanged, the respective volumes of the combustible gas and the combustion-supporting gas introduced into the combustion chamber 100 are substantially constant values. Flow rates of the combustible gas and the combustion-supporting gas when being introduced into the combustion chamber 100 are related to the process time, that is, the volume of the combustible gas introduced into the combustion chamber 100 is not necessarily larger in a case where the flow rate of the combustible gas is higher; correspondingly, the volume of the combustible gas introduced into the combustion chamber 100 is not necessarily smaller in a case where the flow rate of the combustible gas is lower.

As described above, the combustion-supporting gas can be delivered into the combustion chamber 100 through the purge pipeline 220 to replace the original gas in the combustion chamber 100. In order to further improve efficiency and completeness of expelling the original gas from the combustion chamber 100, in an embodiment of the present disclosure, the ignition chamber may further include a dispersion plate 300, which is disposed in the combustion chamber 100, and is spaced apart from the two opposite ends of the combustion chamber 100. That is, the dispersion plate 300 is located at a position between the two opposite ends of the combustion chamber 100 in the axial direction of the combustion chamber 100.

Meanwhile, the dispersion plate 300 is provided with a communicating hole and a plurality of dispersion holes, and the communicating hole and each dispersion hole penetrate through the dispersion plate 300, so as to ensure that the gases can flow back and forth from two opposite sides of the dispersion plate 300. One end of the communication pipeline 210 communicates with the communicating hole, so that the combustion product and the residual oxygen in the combustion chamber 100 may flow into the communication pipeline 210 through the communicating hole, and may be finally delivered into the process chamber 500. Moreover, since each dispersion hole penetrates through the dispersion plate 300, the purge pipeline 220 disposed at the first end of the combustion chamber 100 may communicate with the exhaust pipeline 230 through the plurality of dispersion holes, and the combustion-supporting gas output through the purge pipeline 220 may flow to a side of the dispersion plate 300 away from the purge pipeline 220 through the plurality of dispersion holes, so that the combustion-supporting gas output through the purge pipeline 220 can produce a good purging effect, thereby improving efficiency and effect of purging the original gas from the combustion chamber 100.

In an embodiment, the dispersion plate 300 may be made of a high-temperature-resistant material such as metal or quartz, and may be fixed in the combustion chamber 100 by welding or bonding. In an embodiment, since the two opposite sides of the dispersion plate 300 are not necessarily isolated from each other, the dispersion plate 300 may be only embedded in the combustion chamber 100 without being fixedly connected to the combustion chamber 100.

In addition, in the presence of the dispersion plate 300, in a case where the flow rate of hydrogen is relatively high, the dispersion plate 300 can disperse the combustion-supporting gas input through the purge pipeline 220 when the combustion-supporting gas is delivered into the combustion chamber 100 through the purge pipeline 220, so that deceleration and dispersion effects of the combustion-supporting gas on hydrogen can be further improved, and the combustion completeness of hydrogen can be further improved.

As described above, the dispersion plate 300 is disposed between the two opposite ends of the combustion chamber 100; and in an embodiment of the present disclosure, a distance between the dispersion plate 300 and the first end of the combustion chamber 100 is smaller than that between the dispersion plate 300 and the second end of the combustion chamber 100. That is, a distance between the dispersion plate 300 and the purge pipeline 220 is smaller than that between the dispersion plate 300 and the first gas inlet pipeline 240. Thus, the distance between the second end of the combustion chamber 100 and the dispersion plate 300 is larger, resulting in a larger space for the combustion of hydrogen and oxygen; in addition, the gas delivered into the combustion chamber 100 through the purge pipeline 220 can fill the space between the first end of the combustion chamber 100 and the dispersion plate 300 in as short a time as possible, and the combustion-supporting gas can uniformly flow to the side of the dispersion plate 300 facing the second end of the combustion chamber 100 through the plurality of dispersion holes in the dispersion plate 300, resulting in improved distribution uniformity of the combustion-supporting gas delivered into the combustion chamber 100 through the purge pipeline 220.

In the above embodiments, the combustion chamber 100 may have the straight structure, and may have a hollow internal structure to provide an accommodating space and a combustion space for the gases. In an embodiment of the present disclosure, any cross section of the combustion chamber 100 along the axial direction thereof has equal area. For example, the combustion chamber 100 has a hollow right prism structure.

In another embodiment of the present disclosure, the combustion chamber 100 includes at least two portions different in cross-sectional area. In details, the combustion chamber 100 includes a first cylinder 110 and a second cylinder 120, one end of the first cylinder 110 communicates with the first gas inlet pipeline 240, one end of the second cylinder 120 communicates with the communication pipeline 210, and the other end of the first cylinder 110 communicates with the other end of the second cylinder 120 to enable the first gas inlet pipeline 240 to communicate with the communication pipeline 210.

A cross-sectional area of an inner cavity of the first cylinder 110 is a first area, a cross-sectional area of an inner cavity of the second cylinder 120 is a second area, and the first area is smaller than second area. The cross-sectional areas are perpendicular to axial directions of the first cylinder 110 and the second cylinder 120. In other words, in the embodiment of the present disclosure, the cross-sectional area of the inner cavity of the portion of the combustion chamber 100 which communicates with the first gas inlet pipeline 240 and the second gas inlet pipeline 250 is smaller while the cross-sectional area of the inner cavity of the portion of the combustion chamber 100 which is connected to the communication pipeline 210 is larger. Therefore, after hydrogen and oxygen are delivered into the combustion chamber 100 through the first gas inlet pipeline 240 and the second gas inlet pipeline 250, hydrogen and oxygen are subjected to a certain dispersion effect when flowing to the second cylinder 120 having the larger cross-sectional area through the first cylinder 110 having the smaller cross-sectional area, which can improve the degree of mixing of hydrogen and oxygen, and further improve combustion efficiency and combustion completeness of hydrogen. In addition, under the condition that the cross-sectional area of the second cylinder 120 is larger, a size of the space enclosed by the inner surface (i.e., a size of the inner cavity) of the second cylinder 120 is larger, so that a larger space is provided for the combustion, and flames produced during the combustion is prevented from being in close contact with the second cylinder 120, which further prolongs service life of the second cylinder 120.

In order to further enhance the dispersion effect on hydrogen and oxygen, in an embodiment of the present disclosure, the combustion chamber 100 further includes a communicating section 130 for connecting the first cylinder 110 to the second cylinder 120, and a cross-sectional area of an inner cavity of the communicating section 130 gradually increases from the first area to the second area in a direction from the first cylinder 110 to the second cylinder 120. That is, in the embodiment of the present disclosure, the communicating section 130 has a flaring structure, which makes the dispersion effect of the combustion chamber 100 on hydrogen and oxygen better, and further improves the combustion efficiency and the combustion completeness of hydrogen. Certainly, in a molding process of the combustion chamber 100, in order to improve structural strength and reliability of the combustion chamber 100, the combustion chamber 100 including the first cylinder 110, the second cylinder 120, and the communicating section 130 may be integrally formed by sintering or by other means.

In order to further improve the combustion efficiency and the combustion completeness of hydrogen and prevent hydrogen from accumulating at edges or corners of the combustion chamber, in an embodiment of the present disclosure, each of the inner surface of the first cylinder 110 and the inner surface of the second cylinder 120 forms a cylindrical lateral surface structure; correspondingly, in order to reduce processing difficulty of the first cylinder 110 and the second cylinder 120, respective outer surfaces of the first cylinder 110 and the second cylinder 120 may also form cylindrical lateral surface structures. Moreover, by making both an inner surface and an outer surface of the communicating section 130 form frustum lateral surface structures, the number of dead zones in the combustion chamber 100 can be further reduced. Certainly, parameters such as inner diameters and outer diameters of the first cylinder 110 and the second cylinder 120 may be flexibly determined based on actual situations, and are not limited herein.

As described above, the communication pipeline 210 and the purge pipeline 220 are both disposed at the first end of the combustion chamber 100, and the first gas inlet pipeline 240, the second gas inlet pipeline 250, and the exhaust pipeline 230 are disposed at the second end of the combustion chamber 100. In a case where the combustion chamber 100 includes the first cylinder 110 and the second cylinder 120 described above, in view of a smaller size of the first cylinder 110, in order to reduce installation difficulty of the first gas inlet pipeline 240, the second gas inlet pipeline 250, and the exhaust pipeline 230, the first gas inlet pipeline 240 and the second gas inlet pipeline 250 may be both connected to an end surface of the first cylinder 110, and the exhaust pipeline 230 may be connected to a sidewall of the first cylinder 110. Thus, hydrogen and oxygen delivered into the combustion chamber 100 through the first gas inlet pipeline 240 and the second gas inlet pipeline 250 can have initial velocities in the axial direction of the combustion chamber 100, which facilitates delivering the combustion product and the residual oxygen into the process chamber 500 through the communication pipeline 210 at the first end of the combustion chamber 100, and reduces the installation difficulty of the exhaust pipeline 230; in addition, the exhaust pipeline 230 can be prevented from interfering with installation of the heating element 400 if hydrogen and oxygen are heated by disposing the heating element 400 outside the first gas inlet pipeline 240 and the second gas inlet pipeline 250.

Meanwhile, in order to ensure that an impurity gas can be completely discharged out of the combustion chamber 100 through the exhaust pipeline 230, a distance between the exhaust pipeline 230 and an end of the first cylinder 110 where the first gas inlet pipeline 240 is located in the axial direction of the first cylinder 110 is smaller than a distance between the exhaust pipeline 230 and an end of the first cylinder 110 away from the first gas inlet pipeline 240 in the axial direction of the first cylinder 110. That is, during the design of a location of the exhaust pipeline 230, the exhaust pipeline 230 still needs to be disposed as close as possible to the end of the first cylinder 110 where the first gas inlet pipeline 240 is located, that is, the second end of the combustion chamber 100 away from the purge pipeline 220.

Since the second cylinder 120 has a larger size and no other device needs to be disposed outside the communication pipeline 210, in an embodiment of the present disclosure, the communication pipeline 210 and the purge pipeline 220 may be both connected to an end surface of the second cylinder 120, so as to facilitate installation and assembly of the combustion chamber 100. In addition, in order to reduce difficulty of the combustion product generated in the combustion chamber 100 and the residual oxygen in flowing into the communication pipeline 210, in an embodiment of the present disclosure, the communication pipeline 210 may be located at a central region of the second cylinder 120 along a direction perpendicular to the axial direction of the second cylinder 120, so that the combustion product and the gas in the combustion chamber 100 can easily flow to the communication pipeline 210; meanwhile, the purge pipeline 220 is located on an outer side of the communication pipeline 210, which can also ensure normal delivery of the combustion-supporting gas into the combustion chamber 100 through the purge pipeline 220.

Based on the ignition chamber of the semiconductor process equipment provided in any of the above embodiments, as shown in FIG. 3, an embodiment of the present disclosure further provides a semiconductor process equipment, including a process chamber 500 and the ignition chamber of the semiconductor process equipment provided in the above embodiments of the present disclosure; and an end of the communication pipeline 210 of the ignition chamber which is away from the combustion chamber 100 communicates with the process chamber 500, so that a combustion product generated in the combustion chamber 100 and residual oxygen can be delivered into the process chamber 500 through the communication pipeline 210, and subjected to a wet oxidation process with a workpiece to be processed in the process chamber 500, so as to form a silicon dioxide film on a surface of the workpiece to be processed.

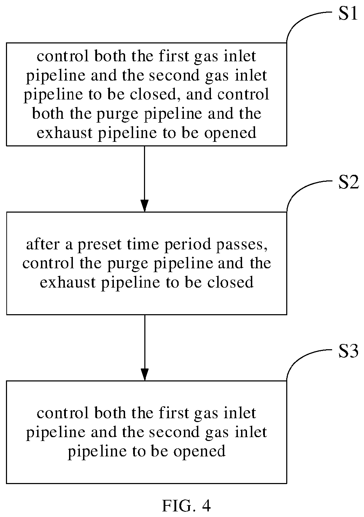

Further, as shown in FIG. 4, an embodiment of the present disclosure further provides a control method applicable to the semiconductor process equipment provided in the above embodiments of the present disclosure, and the control method includes the following steps S1 to S3.

At S1, the first gas inlet pipeline 240 and the second gas inlet pipeline 250 are both controlled to be closed, and the purge pipeline 220 and the exhaust pipeline 230 are both controlled to be opened. That is, before the combustible gas such as hydrogen and the combustion-supporting gas such as oxygen are introduced into the combustion chamber 100 through the first gas inlet pipeline 240 and the second gas inlet pipeline 250, purging is first performed on the combustion chamber 100 through the purge pipeline 220, and the original gas in the combustion chamber 100 and a purge gas are discharged out of the combustion chamber 100 through the exhaust pipeline 230. Thus, the phenomenon that the purge gas and the original gas and impurities in the combustion chamber 100 flow to the process chamber 500 through the communication pipeline 210 can be greatly alleviated or even avoided, which improves process effect and success rate.

At S2, after a preset time period passes, the purge pipeline 220 and the exhaust pipeline 230 are controlled to be closed. That is, after the purge gas is continuously introduced into the combustion chamber 100 through the purge pipeline 220 for the preset time period, it is considered that the original gas in the combustion chamber 100 can be expelled, at this time, the purge pipeline 220 and the exhaust pipeline 230 need to be closed for normal combustion.

At S3, the first gas inlet pipeline 240 and the second gas inlet pipeline 250 are controlled to be opened, that is, hydrogen and oxygen may be introduced after the original gas in the combustion chamber 100 is expelled with the purge gas introduced through the purge pipeline 220, so that hydrogen and oxygen may undergo a combustion reaction in the combustion chamber 100 and generate water vapor, and the water vapor and the residual oxygen may be delivered into the process chamber 500 through the communication pipeline 210 for a wet oxidation process with a workpiece to be processed.

It should be noted that in the control method provided in the embodiment of the present disclosure, the purge gas delivered into the combustion chamber 100 through the purge pipeline 220 at least includes the combustion-supporting gas, i.e., oxygen; moreover, it may be determined based on actual needs whether to introduce nitrogen into the combustion chamber 100 before introducing oxygen through the purge pipeline 220. In an embodiment, a device for performing a control function in the above control method may be a controller.

If a flow rate of hydrogen is relatively high during combustion, hydrogen may not completely burn due to the relatively high flow rate, and may directly flow into the process chamber 500 through the communication pipeline 210 and react with oxygen in the process chamber 500 to generate heat, which causes a significant adverse effect on temperature uniformity in the process chamber, and further leads to failure in the wet oxidation process.

In view of the above, in an embodiment of the present disclosure, step S3 further includes:
S31, controlling both the first gas inlet pipeline 240 and the second gas inlet pipeline 250 to be opened, and controlling the purge pipeline 220 to be closed in a case where a flow rate of the combustible gas is lower than or equal to a reference flow rate; or
S32, controlling both the first gas inlet pipeline 240 and the second gas inlet pipeline 250 to be opened, and controlling the purge pipeline 220 to be opened in a case where a flow rate of the combustible gas is higher than a reference flow rate.

That is, in the embodiment of the present disclosure, an on/off state of the purge pipeline 220 may be controlled based on the flow rate of the combustible gas (e.g., hydrogen), and in a case where the flow rate of the combustible gas (e.g., hydrogen) is relatively low, the purge pipeline 220 is not used to introduce the combustion-supporting gas (e.g., oxygen) into the combustion chamber 100, so as to reduce control difficulty of the semiconductor process equipment; and in a case where the flow rate of the combustible gas (e.g., hydrogen) is relatively high, the purge pipeline 220 may be used to introduce the combustion-supporting gas (e.g., oxygen) into the combustion chamber 100 along a direction opposite to a flow direction of the combustible gas (e.g., hydrogen), so as to improve combustion efficiency and combustion completeness of the combustible gas (e.g., hydrogen), and prevent the unburnt combustible gas (e.g., hydrogen) from flowing into the process chamber 500 to affect normal operation of the wet oxidation process.

It should be noted that the terms "include", "comprise" or any other variation thereof are intended to indicate a non-exclusive inclusion, so that a process, method, article, or device, which includes a series of elements, does not only include those listed elements but also include other elements which are not explicitly listed, or the elements inherent in such process, method, article, or device. If there are no more limitations, limiting an element by "including a..." does not exclude the existence of other identical elements in the process, method, article, or device which includes the element. Further, it should be noted that the scope of the method and device provided in the implementations of the present disclosure is not limited to performing functions in the order illustrated or discussed herein, but may include performing the functions in a substantially simultaneous manner or in a reverse order based on the functions. For example, the method described herein may be performed in an order different from that described herein, and steps may be added, omitted, or combined. In addition, the features illustrated by a certain example may be combined in other examples.

The embodiments of the present disclosure are described above with reference to the drawings, but the present disclosure is not limited to the above specific implementations which are just for illustration rather than for limitation. Enlightened by the present disclosure, those of ordinary skill in the art can make many variations in forms without departing from the spirit of the present disclosure and the scope of the claims, and all those variations should be considered to fall within the scope of the present disclosure.

## Claims

1. An ignition chamber of a semiconductor process equipment, comprising a combustion chamber, a communication pipeline, a purge pipeline, an exhaust pipeline, a first gas inlet pipeline, and a second gas inlet pipeline, wherein
one end of the communication pipeline and one end of the purge pipeline respectively communicate with a first end of the combustion chamber, and the other end of the purge pipeline is configured to communicate with a combustion-supporting gas source; and
one end of the exhaust pipeline, one end of the first gas inlet pipeline, and one end of the second gas inlet pipeline respectively communicate with a second end of the combustion chamber opposite to the first end of the combustion chamber, the other end of one of the first gas inlet pipeline and the second gas inlet pipeline is configured to communicate with a combustible gas source, and the other end of the other of the first gas inlet pipeline and the second gas inlet pipeline is configured to communicate with the combustion-supporting gas source.

2. The ignition chamber of the semiconductor process equipment of claim 1, further comprising a dispersion plate, which is disposed in the combustion chamber, and is spaced apart from the two opposite ends of the combustion chamber; and
the dispersion plate is provided with a communicating hole and a plurality of dispersion holes, the communicating hole and each of the dispersion holes penetrate through the dispersion plate, one end of the communication pipeline communicates with the communicating hole, and the purge pipeline communicates with the exhaust pipeline through the plurality of dispersion holes.

3. The ignition chamber of the semiconductor process equipment of claim 2, wherein a distance between the dispersion plate and the first end of the combustion chamber is smaller than a distance between the dispersion plate and the second end of the combustion chamber.

4. The ignition chamber of the semiconductor process equipment of claim 1, wherein the combustion chamber comprises a first cylinder and a second cylinder, one end of the first cylinder communicates with the first gas inlet pipeline, one end of the second cylinder communicates with the communication pipeline, the other end of the first cylinder communicates with the other end of the second cylinder, a cross-sectional area of an inner cavity of the first cylinder is a first area, a cross-sectional area of an inner cavity of the second cylinder is a second area, and the first area is smaller than the second area.

5. The ignition chamber of the semiconductor process equipment of claim 4, wherein the combustion chamber further comprises a communicating section, the first cylinder and the second cylinder are connected to each other through the communicating section, and a cross-sectional area of an inner cavity of the communicating section gradually increases from the first area to the second area in a direction from the first cylinder to the second cylinder.

6. The ignition chamber of the semiconductor process equipment of claim 5, wherein each of an inner surface of the first cylinder and an inner surface of the second cylinder forms a cylindrical lateral surface structure, and an inner surface of the communicating section forms a frustum lateral surface structure.

7. The ignition chamber of the semiconductor process equipment of claim 4, wherein the first gas inlet pipeline and the second gas inlet pipeline are both connected to an end surface of the first cylinder, the exhaust pipeline is connected to a sidewall of the first cylinder, and a distance between the exhaust pipeline and an end of the first cylinder where the first gas inlet pipeline is located in an axial direction of the first cylinder is smaller than a distance between the exhaust pipeline and an end of the first cylinder away from the first gas inlet pipeline in the axial direction of the first cylinder; and
the communication pipeline and the purge pipeline are both connected to an end surface of the second cylinder, the communication pipeline is located at a central region of the second cylinder along a direction perpendicular to an axial direction of the second cylinder, and the purge pipeline is located on an outer side of the communication pipeline.

8. A semiconductor process equipment, comprising a process chamber and the ignition chamber of the semiconductor process equipment of any one of claims 1 to 7, and one end of the communication pipeline away from the combustion chamber communicating with the process chamber.

9. A control method applied to the semiconductor process equipment of claim 8, comprising:
controlling both the first gas inlet pipeline and the second gas inlet pipeline to be closed, and controlling both the purge pipeline and the exhaust pipeline to be opened;
after a preset time period passes, controlling the purge pipeline and the exhaust pipeline to be closed; and
controlling both the first gas inlet pipeline and the second gas inlet pipeline to be opened.

10. The control method of claim 9, wherein controlling both the first gas inlet pipeline and the second gas inlet pipeline to be opened comprises:
controlling both the first gas inlet pipeline and the second gas inlet pipeline to be opened, and controlling the purge pipeline to be closed in a case where a flow rate of a combustible gas is lower than or equal to a reference flow rate; or
controlling both the first gas inlet pipeline and the second gas inlet pipeline to be opened, and controlling the purge pipeline to be opened in a case where a flow rate of a combustible gas is higher than a reference flow rate.
